# EUROPEAN PATENT APPLICATION

(11) **EP 2 579 343 A2**
(43) Date of publication of application: **10.04.2013**
(21) Application number: 12006466.2
(22) Date of filing: 14.09.2012
(51) Int. Cl.: H01L 33/44

(54) **Light-emitting element including light-emitting layer sandwiched between two semiconductor layers**

(30) Priority: 04.10.2011 JP 2011220137
(71) Applicant: Sharp Kabushiki Kaisha, Osaka-shi, Osaka 545-8522 (JP)
(72) Inventor: Yoshida, Shinya, Osaka-shi Osaka 545-8522 (JP)
(74) Representative: Müller - Hoffmann & Partner

(57) **Abstract**

A light-emitting element (501) includes a sapphire substrate (1) as a substrate, a light-emitting layer (3) arranged on the substrate in a state of being sandwiched in a thickness direction between an n-type semiconductor layer (2) and a p-type semiconductor layer (4) as two semiconductor layers having conductivity types different from one another, and a transparent electrode layer (5) arranged so as to overlap with p-type semiconductor layer (4) as one of the two semiconductor layers located farther away from the substrate, and a flat layer (8) of a transparent material having a higher refractive index than transparent electrode layer (5) and provided so as to cover at least a part of an upper surface of transparent electrode layer (5), and a irregularity layer (9) arranged on an upper side of said flat layer (8).

## Description

This nonprovisional application is based on Japanese Patent Application No. 2011-220137 filed on October 4, 2011 with the Japan Patent Office, the entire contents of which are hereby incorporated by reference.

### BACKGROUND OF THE INVENTION

### Field of the Invention

The present invention relates to a light-emitting element including a light-emitting layer sandwiched between two semiconductor layers.

### Description of the Background Art

Since a light-emitting diode has a high photoelectric conversion efficiency, and emission of blue light has become possible in recent years, a light-emitting diode is attracting attention as a next-generation illumination light source with a low environmental load. In order to take sufficient advantage of a high photoelectric conversion efficiency of the light-emitting diode, extraction of a light beam generated at a PN-junction without loss is important. However, since a compound semiconductor generally enabling fabrication of a light-emitting diode has a high refractive index, a light beam is absorbed by an electrode made of metal and a semiconductor layer as total reflection of the light beam is repeated in a chip, thus the light beam extracted from the chip is reduced.

A blue light-emitting diode currently on the mainstream is fabricated using a GaN semiconductor. However, since GaN has a refractive index of 2.5, the critical angle becomes 3.6° in the case of placing GaN in the air, thus a light beam extracted from the chip remain at about 10%.

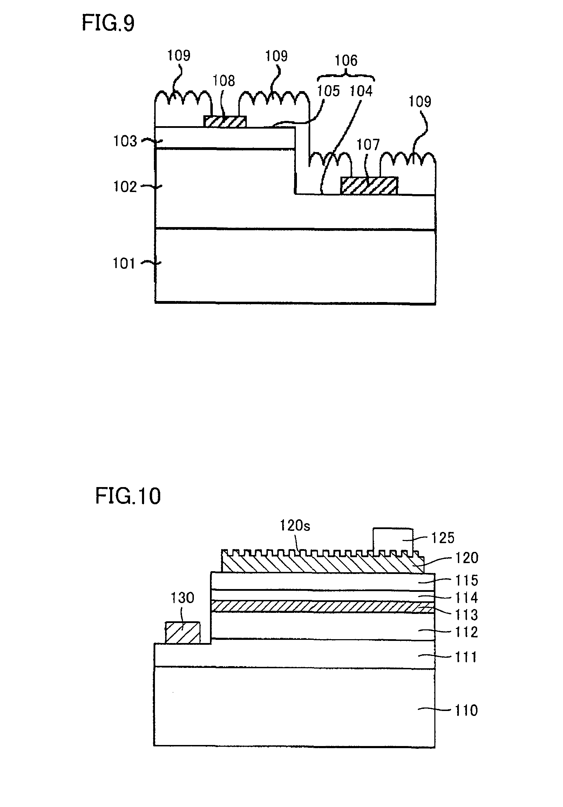

The efficiency in extracting a generated light beam from a chip is generally referred to as a light-extraction efficiency. As a technology for improving the light-extraction efficiency, Japanese Patent Laying-Open No. 10-163525 (PTL 1) proposes a configuration provided with irregularities on a transparent electrode of a chip, as shown in Fig. 9.

Fig. 9 shows a structure including a sapphire substrate 101, an n-type GaN layer 102 formed on sapphire substrate 101, and a p-type GaN layer 103 formed on n-type GaN layer 102. This structure has a shape such that a part extending from p-type GaN layer 103 to a predetermined position of n-type GaN layer 102 is removed to expose n-type GaN layer 102, and the lowered part serves as an n-type electrode forming region 104. This removal concurrently forms a p-type electrode forming region 105 to be formed on an upper surface of p-type GaN layer 103. Here, the region extending from p-type electrode forming region 105 to n-type electrode forming region 104 is referred to as a light-extraction surface 106.

An n-type electrode 107 is formed on n-type electrode forming region 104, and a p-type electrode 108 is formed on p-type electrode forming region 105. Since p-type electrode forming region 105 is usually wider than n-type electrode forming region 104, a transparent electrode of a transparent conductive film, not illustrated, made of ITO or the like is formed on p-type electrode forming region 105, and a p-type electrode 108 is formed on the transparent electrode.

On substantially the entire region of light-extraction surface 106, a light scattering layer 109 made of silicon dioxide (SiO₂) is formed. Light scattering layer 109 has an irregular surface with a width and a level difference of about 0.3 µm. Since irregularities are formed on the surface of light scattering layer 109, light beam incident at an incident angle greater than the critical angle is extracted from the chip by diffraction. As a result, the light-extraction efficiency is improved.

Further, improvement of the light-extraction efficiency by providing an irregularity structure on the transparent electrode has also been considered. An example is disclosed in Japanese Patent Laying-Open No. 2008-294306 (PTL 2).

As shown in Fig. 10, a group-III nitride-based compound semiconductor light-emitting element is provided with a buffer layer, not illustrated, on a sapphire substrate 110. The buffer layer is made of aluminum nitride (AlN) and has a thickness of about 15 nm. On the buffer layer, an n-contact layer 111 is formed. N-contact layer 111 is made of GaN doped with silicon (Si) and has a thickness of about 4 µm. On n-contact layer 111, an n-clad layer 112 is formed. N-clad layer 112 is a multilayer with ten sets of stacked layers and has a thickness of about 74 nm. Each set of stacked layers of n-clad layer 112 includes undoped In_{0.1}Ga_{0.9}N, undoped GaN, and GaN doped with silicon (Si). On n-clad layer 112, a light-emitting layer 113 having a multi-quantum well structure (MQW) is formed including eight sets of alternately stacked layers. Each set of stacked layers of light-emitting layer 113 includes a well layer made of In_{0.2}Ga_{0.8}N and having a thickness of about 3 nm and a barrier layer made of Al_{0.06}Ga_{0.94}N and having a thickness of 3 nm. On light-emitting layer 113, a p-clad layer 114 is formed. P-clad layer 114 is a multilayer made of p-type Al_{0.3}Ga_{0.7}N and p-type In_{0.08}Ga_{0.92}N and has a thickness of about 33 nm. Further, on p-clad layer 114, a p-contact layer 115 is formed. P-contact layer 115 has a stacked layer structure constituted by two layers of p-type GaN having different magnesium concentrations and has a thickness of about 80 nm.

On p-contact layer 115, a translucent electrode 120 is formed. Translucent electrode 120 is made of niobium titanium oxide (niobium 3%) and has irregularities 120s. On an exposed surface of n-contact layer 111, an electrode 130 is formed. Electrode 130 is constituted by a vanadium (V) film having a thickness of about 20 nm and an aluminum (Al) film having a thickness of about 2 µm. At a part on translucent electrode 120, an electrode pad 125 made of gold (Au) alloy is formed.

In the art disclosed in PTL 2, an optical output has been improved by 30%, as compared to the case where no irregularities 120s are present.

However, the niobium titanium oxide disclosed in PTL 2 needs to be adjusted such that its crystal orientation (C axis) becomes perpendicular to the film surface to obtain a conductivity similar to that of general ITO (Indium Tin Oxide). However, the general sputtering method causes the crystal axis to be randomly oriented, thus a resistance value of the niobium titanium oxide becomes equal to or greater than twice the resistance value of ITO. This causes a bias in the current density distribution on the element, resulting in inconvenience such as increase in non-effective power consumption or rise in the operating voltage.

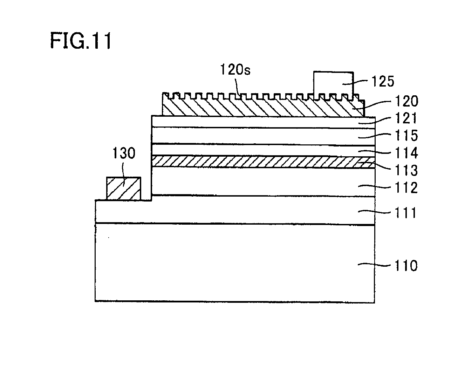

In PTL 2, as a structure of a light-emitting element compensating for the above-described disadvantage, the structure shown in Fig. 11 is disclosed. In the structure shown in Fig. 11, a translucent conductive layer 121 made of indium tin oxide (ITO) and having a thickness of 50 nm (less than 1/(4n) of a light emission wavelength 470 nm of light emitting layer 113, where "n" is a refractive index of ITO) is formed between p-contact layer 115 made of p-type GaN and translucent electrode 120 made of niobium titanium oxide (niobium 3%),

In this structure, translucent conductive layer 121 made of ITO with a low resistivity compensates for a high lateral diffusion resistance of niobium titanium oxide. To suppress the total reflection at the interface between translucent conductive layer 121 made of ITO with a low refractive index and p-contact layer 115 made of p-type GaN with a high refractive index, the thickness of translucent conductive layer 121 made of ITO needs to be set less than 1/4 of the light emission wavelength.

As described above, the niobium titanium oxide disclosed in PTL 2 has a conductivity, and a refractive index of 2.4 close to that of GaN can be achieved. However, to obtain the conductivity similar to that of general ITO in a direction parallel to the film surface, adjustment is necessary to allow the crystal orientation (C axis) to be perpendicular to the film surface. However, the technology of forming the niobium titanium oxide film while adjusting the crystal orientation to be perpendicular to the film surface has not yet been ready for application to mass production. On the other hand, in a case where the niobium titanium oxide film is formed by the general sputtering, a crystal axis is randomly oriented, thus the resistance value of niobium titanium oxide becomes equal to or greater than twice the resistance value of ITO having the same thickness. Thus, the thickness must be twice or greater to adopt niobium titanium oxide and have the resistance value substantially equal to the case of using ITO. The general sputtering requires twice or longer time period for forming a film to achieve this, thus the time required for production is extended disadvantageously.

To compensate for this, as shown in Fig. 11, the method of forming the ITO film between the p-type GaN layer and the translucent electrode made of niobium titanium oxide may be adopted. However, the thickness of the translucent conductive layer made of ITO needs to be less than 1/(4n) (where "n" is a refractive index of ITO) of the light emission wavelength to suppress the total reflection at the interface between the translucent conductive layer made of ITO with a low refractive index and the p-contact layer made of p-type GaN with a high refractive index. As a result, the lateral diffusion resistance cannot be improved drastically.

For the reasons described above, the industrial use of niobium titanium oxide is difficult. As a result, in fact, no option is present other than selecting ITO as a material of a translucent conductive layer for a mass-produced product required to be produced at a low cost.

### SUMMARY OF THE INVENTION

An object of the present invention is to provide a light-emitting element having an improved light-extraction efficiency.

To achieve the object described above, the light-emitting element in accordance with the present invention includes a substrate, a light-emitting layer arranged on a surface of the substrate in a state of being sandwiched in a thickness direction between two semiconductor layers having conductivity types different from one another, a transparent electrode layer arranged so as to overlap with one of the two semiconductor layers located farther away from the substrate, and a flat layer made of a transparent material with a refractive index higher than the transparent electrode layer and provided so as to cover at least a part of an upper surface of the transparent electrode layer. An irregularity layer is provided on an upper side of the flat layer.

According to the present invention, setting the thickness of the flat layer to be equal to or greater than the thickness allowing guidance of a light beam, in other words, a cut-off thickness, enables activation of a waveguide mode for allowing propagation in this flat layer for a light beam incident at an angle equal to or greater than a critical angle from the light emitting layer to the transparent electrode layer, thus the optical power of the light-emitting layer is shifted to the waveguide mode. This operation enables extraction of the optical power from the light emitting layer to a flat layer with a high refractive index even when the thickness of the transparent electrode layer is equal to or greater than 1/4 of the wavelength. Further, the irregularity structure of irregularity layer 9 present on the upper side of the flat layer interferes with the waveguide mode, so that the waveguide mode is converted to a light beam emitted out of the light-emitting element. The operation principle described above improves the light-extraction efficiency.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross sectional view of a light-emitting element in accordance with a first embodiment of the present invention.
Fig. 2A and Fig. 2B are graphs for describing the operation principle of the light-emitting element in accordance with the first embodiment of the present invention.
Fig. 3 is a graph representing the relationship between a flat layer minimum thickness and a refractive index calculated based on a first calculation model.
Fig. 4 is a graph representing the relationship between a flat layer minimum thickness and a refractive index calculated based on a second calculation model.
Fig. 5 represents a calculation result obtained using parameters shown in Table 1.
Fig. 6 represents a calculation result obtained using parameters shown in Table 2.
Fig. 7 represents a calculation result obtained using parameters shown in Table 3.
Fig. 8 represents a calculation result obtained using parameters shown in Table 4.
Fig. 9 is a cross-sectional view of a first light-emitting element in accordance with conventional art.
Fig. 10 is a cross-sectional view of a second light-emitting element in accordance with conventional art.
Fig. 11 is a cross-sectional view of a third light-emitting element in accordance with conventional art.

### DESCRIPTION OF THE PREFERRED EMBODIMENTS

### (First Embodiment)

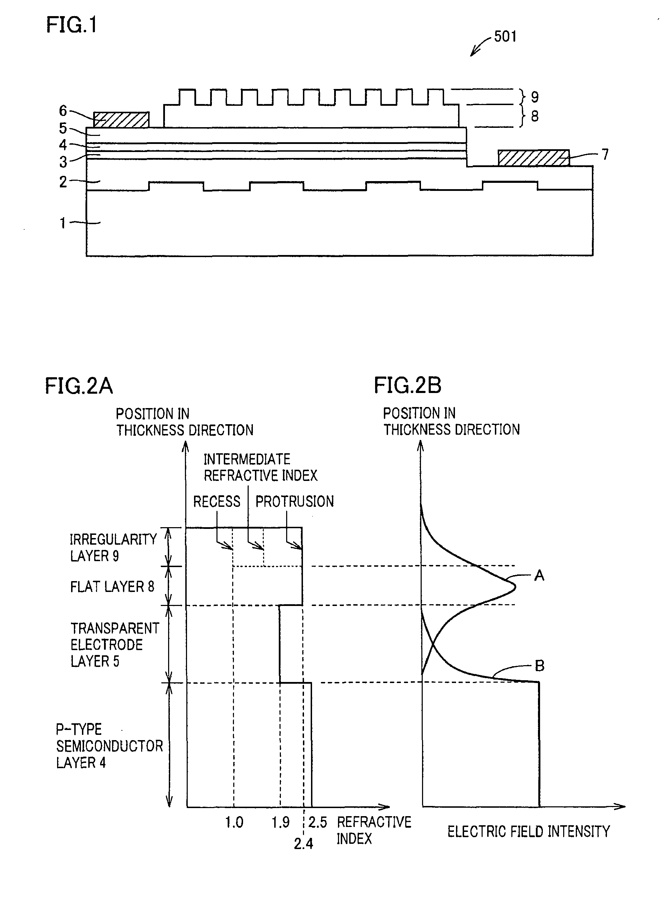

A light-emitting element in accordance with the first embodiment of the present invention will be described with reference to Fig. 1. A light-emitting element 501 in accordance with the present embodiment includes a sapphire substrate 1 as a substrate, a light-emitting layer 3 arranged on a surface of the substrate in a state of being sandwiched in a thickness direction between an n-type semiconductor layer 2 and a p-type semiconductor layer 4 as two semiconductor layers having conductivity types different from one another, a transparent electrode layer 5 arranged so as to overlap with p-type semiconductor layer 4 as one semiconductor layer located farther apart from the substrate among the two semiconductor layers, a flat layer 8 made of a transparent material with a refractive index higher than transparent electrode layer 5 and provided so as to cover at least a part of an upper surface of transparent electrode layer 5, and an irregularity layer 9 arranged on an upper side of flat layer 8.

N-type semiconductor layer 2 is, for example, an n-type gallium nitride (n-GaN) layer. P-type semiconductor layer 4 is, for example, a p-type gallium nitride (p-GaN) layer. Transparent electrode layer 5 is, for example, an indium tin oxide (ITO) film.

Light-emitting element 501 is provided with a p-side electrode 6 and an n-side electrode 7. P-side electrode 6 is arranged on the upper surface of transparent electrode layer 5, and n-side electrode 7 is arranged on a region exposing the upper surface of n-type semiconductor layer 2.

Preferably, the refractive index of flat layer 8 is close to the refractive index of n-type semiconductor layer 2 or of p-type semiconductor layer 4. In a case where n-type semiconductor layer 2 is an n-type nitride gallium layer, or in a case where p-type semiconductor layer 4 is a p-type nitride gallium layer, it is preferable to set the refractive index of flat layer 8 is preferably set to be equal to or greater than 2.2, or more preferably equal to greater than 2.4.

Preferably, flat layer 8 has a thickness allowing propagation of light in flat layer 8. This is because the propagation of light in flat layer 8 can improve the light-extraction efficiency.

Light-emitting element 501 in the present embodiment is provided with flat layer 8 with a high refractive index on transparent electrode layer 5, and irregularity layer 9 is formed on an upper side of flat layer 8. Setting a thickness of flat layer 8 to be equal to or greater than the thickness allowing guidance of light, in other words, equal to or greater than a cut-off thickness enables activation of the waveguide mode to allow propagation of light, incident at an angle equal to or greater than a critical angle from light emitting layer 3 to transparent electrode layer 5, in flat layer 8, thus the optical power of light emitting layer 3 is shifted to the waveguide mode. This operation enables extraction of the optical power from light emitting layer 3 to flat layer 8 with a high refractive index even when the thickness of transparent electrode layer 5 is equal to or greater than 1/4 of the wavelength. Further, the irregularity structure of irregularity layer 9 on an upper side of flat layer 8 interferes with the waveguide mode, so that the optical power is converted into a light beam irradiated out from light-emitting element 501. The operation principle described above improves the light-extraction efficiency.

As described above, preferably, the refractive index of the material of flat layer 8 is equal to or greater than 2.2. The materials capable of achieving this includes TiO₂ (n = 2.6-2.9), ZrO₂ (n = 2.2), Ta₂O₅ (n = 2.3), and diamond (n = 2.4). The number indicated in the parenthesis represents a refractive index "n" of each material.

TiO₂ is the most suitable for the material of flat layer 8 because it has the highest refractive index and incurs low cost. Thus, flat layer 8 is preferably formed of TiO₂ as a main material.

Preferably, the thickness of flat layer 8 is equal to or greater than 30 nm and equal to or less than 150 nm. Here, the condition "equal to or greater than 30 nm" is provided because flat layer 8 needs a thickness equal to or greater than 30 nm to allow propagation of light in flat layer 8. Further, the condition "equal to or less than 150 nm" is provided because, as a result of calculation conducted by the inventors, the effect is saturated or even degraded when the thickness of flat layer 8 is greater than 150 nm. As a result of the calculation conducted by the inventors, it is found out that when the thickness of flat layer 8 is set to be 150 nm, the effect is substantially equal to the level of 100 nm or slightly degraded. This will be described in detail hereinafter.

The irregularity structure of irregularity layer 9 is a grating or a dot pattern having a cycle of pitch substantially equal to or less than a light emission wavelength of 450 nm. Preferably, the pitch of irregularity structure is, for example, 200-500 nm.

In the example shown in Fig. 1, the protrusion of irregularity layer 9 is represented as being continuous and integral with flat layer 8. Irregularity layer 9 includes a protrusion and a space. The space corresponds to a recess. However, since no material is present in the recess, the recess is considered as a space in irregularity layer 9. Preferably, the protrusion is formed of the same material as flat layer 8. In the case of adopting this configuration, flat layer 8 and irregularity layer 9 can be obtained by forming a sufficiently thick film in advance and then etching the film. Therefore, the film forming step associated with flat layer 8 and irregularity layer 9 can be completed at one time.

Alternatively, irregularity layer 9 may be formed of a material different from flat layer 8. For example, flat layer 8 may be formed of TiO₂, and irregularity layer 9 may be formed of a film of SiO₂ and provided on flat layer 8. When the layers are formed of different materials as described above, a pattern difficult to be formed directly on the material of flat layer 8 can be formed easily. In the case of forming irregularity layer 9 with material different from flat layer 8, irregularity layer 9 may have the structure having a thick portion and a thin portion alternately repeated one another, instead of the structure having protrusion and space alternately repeated one another.

Referring to Fig. 2A and Fig. 2B, the operation principle of light-emitting element 501 in accordance with the present invention will be described. Fig. 2A is a graph showing a magnitude relationship of the refractive index at each position in a thickness direction, where the vertical axis represents a position in the thickness direction and the horizontal axis represents a refractive index. Fig. 2B is a graph showing a magnitude relationship of the electric field intensity at each position in a thickness direction, where the vertical axis represents a position in the thickness direction, and the horizontal axis represents the electric field intensity of a light beam. The refractive index of p-type semiconductor layer 4 is 2.5, and the refractive index of the transparent electrode layer is 1.9, and the refractive index of flat layer 8 made of TiO₂ is 2.4. Irregularity layer 9 is provided on an upper side of flat layer 8. The protrusion of irregularity layer 9 is filled with the same material as flat layer 8 is filled, thus the refractive index is 2.4. The recess of irregularity layer 9 is a space, and a space can be assumed as being replaced with an air layer, thus the refractive index is 1.0. The average refractive index of the recess and protrusion corresponds to the intermediate refractive index as shown in the middle of Fig. 2A.

Generally, at the interface between the first medium and the second medium having different refractive indices, when a light beam satisfying the condition of total reflection proceeds from the side of the first medium and then is reflected, in a precise sense, the central axis of the light beam is misaligned horizontally from a geometrically expected position. This is because the light beam proceeded from the side of the first medium enters into the second medium by a small depth of the wavelength order, and then is reflected to proceed to the side of the first medium. This phenomenon is known as Goos-Haenchen effect. The misalignment of the optical axis at this time is referred to as "Goos-Haenchen shift". A depth of slight entry of the light beam into the second medium at the time of this reflection is also referred to as "seepage depth".

Considering the Goos-Haenchen effect in light-emitting element 501, when the light beam generated in light emitting layer 3 passes through p-type semiconductor layer 4, and then enters transparent electrode layer 5 at an angle exceeding the critical angle, light seeps out with a minute depth of wavelength order into transparent electrode layer 5 and then is reflected back into p-type semiconductor 4.

The electric field intensity distribution B in Fig. 2B represents the electric field intensity of the light beam at this occasion. The electric field intensity is constant in p-type semiconductor layer 4, but the intensity is lowered exponentially as coming away from p-type semiconductor layer 4 in transparent electrode layer 5. The portion where electric field intensity distribution B proceeds into transparent electrode layer 5 implies the seepage depth. This seepage depth is about 50 nm.

Usually, ITO is used as a material for a transparent conductive layer. Generally, the conductive layer using ITO needs to have a thickness of 150 nm or greater to lower the resistance value to a practical value. Along with this idea, when the transparent conductive layer made of ITO has a thickness equal to or greater than 150 nm, providing the irregularity structure on the upper surface of the transparent conductive layer does not cause the light beam incident at an angle equal to or greater than critical angle from the lower surface to interfere, thus the light beam is not extracted.

However, when the flat layer is formed of a material with a high refractive index in accordance with the present invention, the waveguide mode having the electric field intensity distribution A presented in Fig. 2B is activated. The electric field intensity distribution A of the waveguide mode and the above-described electric field intensity distribution B overlap in transparent electrode layer 5. The energy is transferred through this overlapping. As a result of this transfer, the energy of light incident to transparent electrode layer 5 from p-type semiconductor layer 4 at an angle greater than the critical angle moves over transparent electrode layer 5 into flat layer 8. Then, the light beam moved into flat layer 8 interferes with the irregularity structure of irregularity layer 9, and emitted outward efficiently. According to the operation principle described above, the light-emitting element in accordance with the present invention can realize a high extraction efficiency.

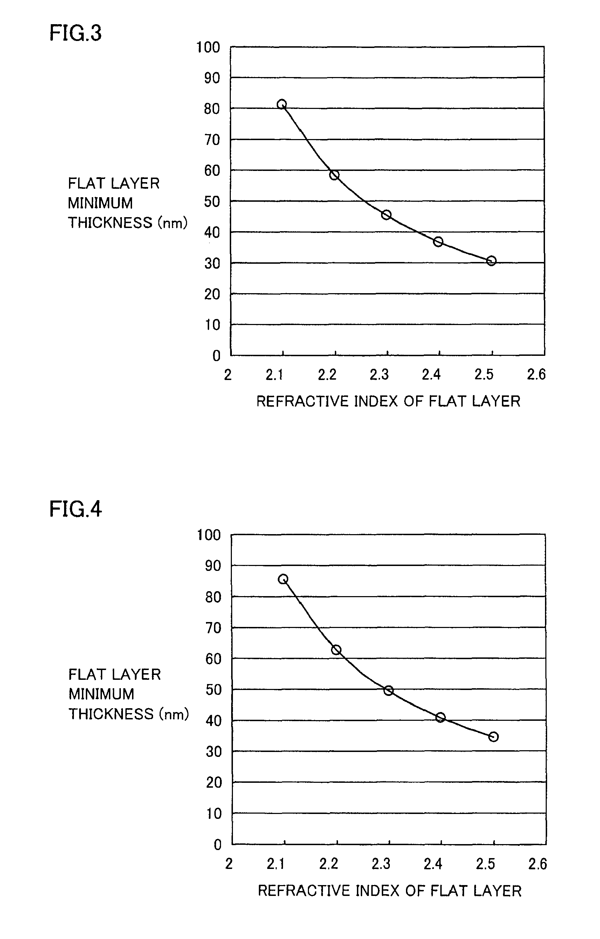

Next, Fig. 3 and Fig. 4 show a relationship between a minimum thickness necessary for propagation of light in flat layer 8 (hereinafter, referred to as "flat layer minimum thickness") and a refractive index of the flat layer. Transparent electrode layer 5 is assumed to be provided under flat layer 8. In Fig. 3, the calculation was conducted under the assumptions that the protrusion of irregularity layer 9 has a refractive index equal to that of flat layer 8 and that the recess is filled with air.

Under the assumption that cylindrical protrusions having a refractive index equal to that of flat layer 8 are arranged in the so-called triangular arrangement, the cylinder of irregularity layer 9 was set to have a diameter half the pitch. The "triangular arrangement" referred herein means that a plurality of cylindrical protrusions are present and that the protrusions are arranged across the entire area of the upper flat surface of flat layer 8 such that each of groups including adjacent three protrusions form a regular triangle.

In the actual calculation, for the sake of simplicity in calculation, the calculation was conducted under the assumption that irregularity layer 9 includes an even layer having a thickness equal to the height of the protrusion and having an intermediate refractive index which will be described hereinafter. The "intermediate refractive index" referred herein is the refractive index calculated based on a refractive index of material filling the protrusion and a refractive index of air filling the recess, taking in consideration the volume of the protrusion and the volume of air filling the recess.

Further, in Fig. 4, the result is shown calculated under the assumption that an air layer (refractive index = 1.0) is present on an upper part of flat layer 8. As a calculation method, the method disclosed in "Light Wave Electronics" (by Jiro Koyama and Hiroshi Nishihara, Corona Publishing Co., Ltd., 1978, pp. 236-239) was used.

In the configuration presenting the basis for the calculation shown in Fig. 3 and Fig. 4, flat layer 8 may be regarded as the portion allowing light to pass through. Generally, when the refractive index is high at the portion allowing the light beam to pass through in a light waveguide passage, the light beam can propagate even when the portion allowing the light beam to pass through is thin. As the refractive index of the portion allowing the light beam to pass through becomes higher, the thickness of the portion allowing the light beam to pass through can be set thinner. In other words, the flat layer minimum thickness can be set smaller. However, since the material having a high refractive index often increases absorption, simply raising the refractive index is not sufficient. Selecting a material having a high refractive index within a required range is critical in practical usage.

Preferably, that the refractive index of flat layer 8 is close to the refractive index of p-type semiconductor layer 4 or of n-type semiconductor layer 2. However, since there is a practical limitation as described above, the maximum value of the refractive index of an industrially usable flat layer is considered to be 2.5. In Fig. 3, when the refractive index of flat layer 8 is 2.5, the flat layer minimum thickness is 30 nm as can be read from Fig. 3. Similarly, the flat layer minimum thickness is 35 nm as can be read from Fig. 4. Thus, in reality, a practical flat layer 8 preferably has a thickness of 30 nm or greater.

When calculating the behavior of waveguide passage in the case where irregularities are provided on the surface, some methods can be considered in light of how to set a calculation model. Since a significant difference may occur in a result when the calculation model is not appropriate, appropriateness of the calculation model should be confirmed by using various calculation methods. This is the reason why the calculation was conducted based on calculation models differing from one another in Fig. 3 and Fig. 4. In Fig. 3, the calculation model is based on the assumption that there is a layer having a refractive index of values obtained by weighted mean of the refractive index of air and protrusion with the volume ratio (ratio of the bottom areas in a case where the protrusion is cylindrical) on the flat layer since the protrusion is affected in its volume ratio. In Fig. 4, the calculation model is based on under the assumption that since the volume of protrusion is small, the refractive index of the irregularity structure has no influence, in other words this is the same as providing an air layer on the flat layer. The inventors calculated in accordance with two ways shown in Fig. 3 and Fig. 4, and obtained results close to each other. Thus, the inventors took the result as being appropriate.

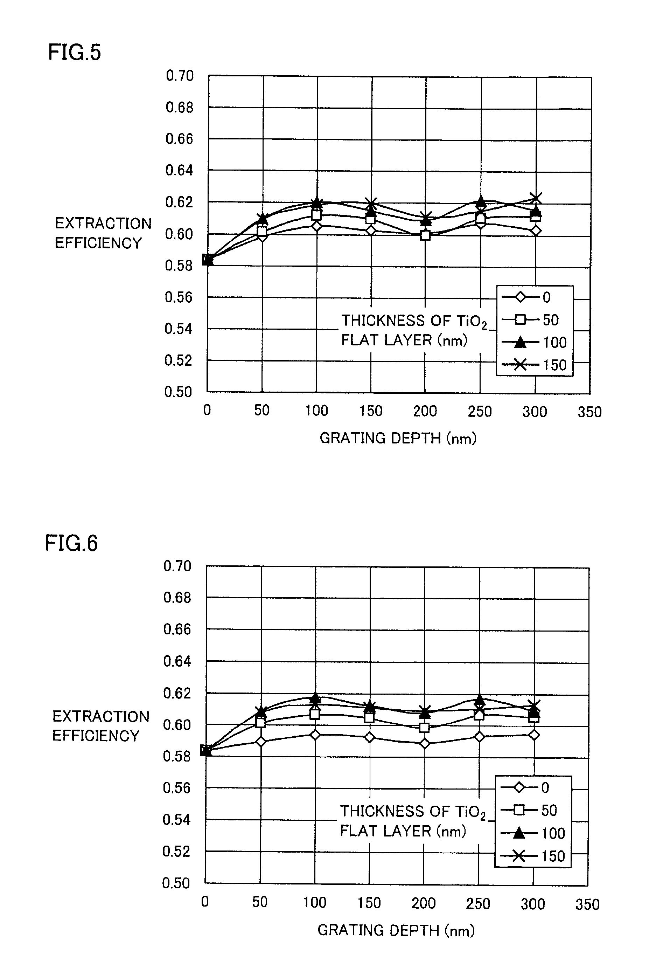

In light-emitting element 501 shown in Fig. 1, the result of calculating the extraction efficiency will be described with reference to Figs. 5-8.

**Table 1**

| Item | Value | Item | Value |
|---|---|---|---|
| Sapphire substrate refractive index | 1.77 | | |
| n-type semiconductor refractive index | 2.5 | n-type semiconductor layer thickness | 7 µm |
| Light-emitting layer refractive index | 2.5 | Light-emitting layer thickness | 20 nm |
| p-GaN layer refractive index | 2.5 | p-GaN layer thickness | 120 nm |
| Transparent electrode layer refractive index | 1.9 | Transparent electrode layer thickness | 70 nm |
| Flat layer refractive index | 2.2 | Flat layer thickness | 0-150 nm |
| Irregularity structure layer refractive index | 2.2 | Irregularity structure layer thickness | 0-300 nm |
| | | Irregularity structure layer cycle | 300 nm |
| | | Light emission wavelength | 450 nm |

Fig. 5 shows the result of calculation using the parameters shown in Table 1. In Fig. 5, the vertical axis represents an extraction efficiency, and the horizontal axis represents a grating depth. The "grating depth" represented by the horizontal axis correspond to the depth of recess of the irregularity structure.

The interface between sapphire substrate 1 and n-type semiconductor layer 2 is assumed to have irregularities of dot pattern having a pitch of 2 µm and a height of 1 µm.

As is clear from Fig. 5, as compared to the case where the thickness of flat layer 8 is zero, in other words, in the case where no flat layer 8 is present, the extraction efficiency becomes higher with the thickness of flat layer 8 set to be 50-150 nm. Since this value is equal to or greater than 30 nm, it conforms to the discussion concerning Fig. 3 and Fig. 4 set forth. Particularly, in a case where the thickness of flat layer 8 is set to be 100-150 nm, the extraction efficiency is higher by about 2% as compared to the case where a flat layer is not present.

**Table 2**

| Items | Value | Items | Value |
|---|---|---|---|
| Sapphire substrate refractive index | 1.77 | | |
| n-type semiconductor refractive index | 2.5 | n-type semiconductor layer thickness | 7 µm |
| Light-emitting refractive index | 2.5 | Light-emitting layer thickness | 20 nm |
| p-type semiconductor layer refractive index | 2.5 | p-type semiconductor layer thickness | 120 nm |
| Transparent electrode layer refractive index | 1.9 | Transparent electrode layer thickness | 140 nm |
| Flat layer refractive index | 2.2 | Flat layer thickness | 0-150 nm |
| Irregularity structure layer refractive index | 2.2 | Irregularity structure layer thickness | 0-300 nm |
| | | Irregularity structure layer cycle | 300 nm |
| | | Light emission wavelength | 450 nm |

Fig. 6 shows the result of calculation using the parameters shown in Table 2. In Table 2, as compared to Table 1, the thickness of transparent electrode layer 7 is increased from 70 nm to 140 nm.

As is clear from Fig. 6, the extraction efficiency becomes higher when flat layer thickness is set to be 50-150 nm as compared to the case where the thickness of flat layer 8 is zero. Particularly, when the thickness of flat layer 8 is set to be 100 nm, the extraction efficiency becomes higher by about 3% as compared to the case where flat layer 8 is not present. Further, from the Table 2 and Fig. 6, it can be read that even when transparent electrode layer 7 has a larger thickness, a light beam can be extracted by using the waveguide mode propagating in flat layer 8.

**Table 3**

| Items | Values | Items | Values |
|---|---|---|---|
| Sapphire substrate refractive index | 1.77 | | |
| n-type semiconductor refractive index | 2.5 | n-type semiconductor layer thickness | 7 µm |
| Light-emitting layer refractive index | 2.5 | Light-emitting layer thickness | 20 nm |
| p-type semiconductor refractive index | 2.5 | p-type semiconductor layer thickness | 120 nm |
| Transparent electrode layer refractive index | 1.9 | Transparent electrode layer thickness | 140 nm |
| Flat layer refractive index | 2.4 | Flat layer thickness | 0-150 nm |
| Irregularity structure layer refractive index | 2.4 | Irregularity structure layer thickness | 0-300 nm |
| | | Irregularity structure layer cycle | 300 nm |
| | | Light emission wavelength | 450 nm |

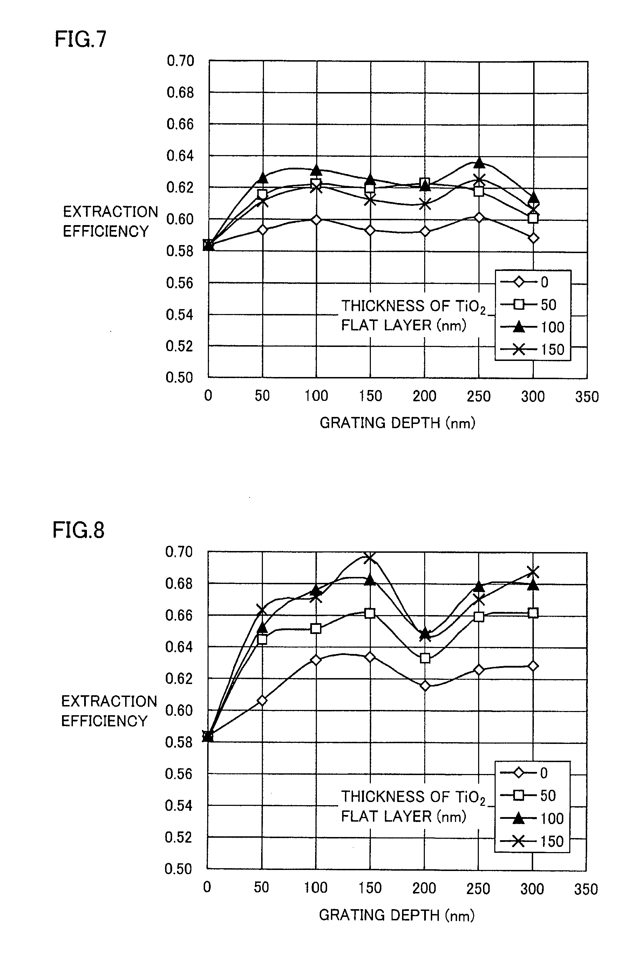

Fig. 7 shows the result of calculation using the parameters shown in Table 3. In Table 3, compared with Table 2, the refractive index of flat layer 8 and irregularity layer 9 is increased from 2.2 to 2.4.

As is clear from Fig. 7, the extraction efficiency becomes higher in a case where the thickness of flat layer 8 is set to be within 50-150 nm as compared to the case where the thickness of flat layer 8 is zero, in other words, no flat layer 8 is present. In a case where, particularly, the thickness of flat layer 8 is set to be 100 nm, the extraction efficiency becomes higher by about 4% as compared to the case where no flat layer 8 is present.

**Table 4**

| Items | Values | Items | Values |
|---|---|---|---|
| Sapphire substrate refractive index | 1.77 | | |
| n-type semiconductor refractive index | 2.5 | n-type semiconductor layer thickness | 7 µm |
| Light-emitting layer refractive index | 2.5 | Light-emitting layer thickness | 20 nm |
| p-type semiconductor refractive index | 2.5 | p-type semiconductor layer thickness | 120 nm |
| Transparent electrode layer refractive index | 1.9 | Transparent electrode layer thickness | 140 nm |
| Flat layer refractive index | 2.4 | Flat layer thickness | 0-150 nm |
| Irregularity structure layer refractive index | 2.4 | Irregularity structure layer thickness | 0-300 nm |
| | | Irregularity structure layer cycle | 250 nm |
| | | Light emission wavelength | 450 nm |

Fig. 8 shows the result of calculation using the parameters shown in Table 4. In Table 4, compared with Table 3, the refractive index of the flat layer 8 and irregularity layer 9 is increased from 2.4 to 2.5, and the cycle of irregularity layer 9 is shortened from 300 nm to 250 nm.

As is clear from Fig. 8, the extraction efficiency becomes higher in a case where the thickness of flat layer 8 is set to be 50-150 nm, as compared to the case where the thickness of flat layer 8 is zero, in other words, no flat layer 8 is present. Particularly, in a case where the thickness of flat layer 8 is set to be 150 nm, the extraction efficiency becomes higher by about 6%, as compared to the case where the flat layer 8 is not present.

According to the calculation results shown in Fig. 5- Fig. 8, four types of thickness of flat layer 8, i.e. 0 nm, 50 nm, 100 nm, 150 nm, are tested. In any of the above cases, the extraction efficiency is improved as the thickness increases from 0 nm, 50 nm and 100 nm. However, a tendency is shown that the extraction efficiency is the same or slightly degraded when the thickness is 150 nm to 100 nm. Thus, the effect is considered to be degraded when the thickness over 150 nm is adopted. Thus, it can be said that the thickness of flat layer 8 is preferably set to be equal to or lower than 150 nm.

Preferably, the thickness of transparent electrode layer 5 is equal to or greater than 1/4 the wavelength of light supplied from light-emitting layer 3. As the transparent electrode layer has more thickness, the electric power loss is reduced by lowering of the resistance value by that amount. Therefore, although it is considered that the thickness is normally set to be equal to or greater than 150 nm, in the conventional technology, it was necessary to set the thickness of transparent electrode layer 5 to be equal to or less than 1/4 of wavelength of light beam in other words, equal to or less than about 50 nm, in order to suppress the total reflection by transparent electrode layer 5. Thus, it was disadvantageous since it was adverse to the power loss reduction in conventional art. It has been considered that setting the thickness of transparent electrode layer 5 to be 1/4 or greater of the wavelength of light supplied form light emitting layer 3 cannot be accommodated by conventional art. According to the present invention, since setting the thickness of transparent electrode layer high to be equal to or greater than 1/4 of wavelength of light beam is effective, setting the thickness of transparent electrode layer 5 to be within this range provides favorable characteristics which could not be obtained by conventional art.

Particularly, it is preferable to set the thickness of transparent electrode layer 5 to be equal to or greater than 70 nm. Such a large thickness of transparent electrode layer can lower the resistance value, which in turn reduces the power loss.

Although the present invention has been described and illustrated in detail, it is clearly understood that the same is by way of illustration and example only and is not to be taken by way of limitation, the scope of the present invention being interpreted by the terms of the appended claims.

## Claims

1. A light-emitting element comprising:
a substrate (1);
a light-emitting layer (3) arranged on a surface of said substrate (1) in a state of being sandwiched in a thickness direction between two semiconductor layers having conductivity types different from one another;
a transparent electrode layer (5) arranged so as to overlap with one of the two semiconductor layers located farther away from said substrate (1);
a flat layer (8) of a transparent material having a higher refractive index than said transparent electrode layer (5) and provided so as to cover at least a part of an upper surface of said transparent electrode layer (5); and
an irregularity layer (9) arranged on an upper side of said flat layer (8).

2. The light-emitting element according to claim 1, wherein said irregularity layer (9) includes a protrusion and a space, and said protrusion is formed of a material identical to the material of said flat layer (8).

3. The light-emitting element according to claim 1, wherein the material of said flat layer (8) has a refractive index equal to or greater than 2.2.

4. The light-emitting element according to claim 1, wherein said flat layer (8) is formed of TiO₂ as a main material.

5. The light-emitting element according to claim 1, wherein a thickness of said flat layer (8) is equal to or greater than 30 nm and equal to or less than 150 nm.

6. The light-emitting element according to claim 1, wherein a thickness of said transparent electrode layer (5) is equal to or greater than 70 nm.

7. The light-emitting element according to claim 1, wherein a thickness of said flat layer (8) is a thickness allowing propagation of light beam in said flat layer (8).

8. The light-emitting element according to claim 1, wherein a thickness of said transparent electrode layer (5) is equal to or greater than 1/4 a wavelength of light supplied from said light-emitting layer (3).
